# EUROPÄISCHE PATENTSCHRIFT

(11) **EP 2 608 399 B1**
(45) Veröffentlichungstag und Bekanntmachung des Hinweises auf die Patenterteilung: **10.08.2016**
(21) Anmeldenummer: 12193647.0
(22) Anmeldetag: 21.11.2012
(51) Int. Cl.: H02M 7/797, H02M 1/32, H02H 7/122, G01R 31/02

(54) **Verfahren zur Erdschlusserkennung beim Betrieb eines Stromrichters**
Method for ground fault detection during operation of a converter
Procédé de détection de défaut de terre pendant l'opération d'un convertisseur

(30) Priorität: 22.12.2011 DE 102011089606
(43) Veröffentlichungstag der Anmeldung: 26.06.2013
(73) Patentinhaber: GE Energy Power Conversion GmbH, 12277 Berlin (DE)
(72) Erfinder: Saniter, Christoph, 14169 Berlin (DE); Boni, Marco, 10627 Berlin (DE); Hildebrandt, Sebastian, 12163 Berlin (DE); Janning, Jörg, 12559 Berlin (DE); Jakob, Roland, 12524 Berlin (DE)
(74) Vertreter: Serjeants LLP

(56) Entgegenhaltungen:
- EP-A2- 1 909 368
- DE-A1- 19 860 721
- US-B1- 7 612 576

## Beschreibung

Die Erfindung betrifft ein Verfahren zum Betreiben einer elektrischen Schaltung sowie eine entsprechende elektrische Schaltung.

Aus der DE 198 60 721 B4 ist ein Verfahren zum Betreiben eines dreistufigen Umrichters bekannt. Dieser Umrichter weist einen Zwischenkreis mit zwei Kondensatoren auf, von deren Verbindungspunkt ein Messwiderstand nach Erde geschaltet ist. Die im Betrieb des Umrichters an dem Messwiderstand abfallende Spannung wird gemessen. In Abhängigkeit von dieser Messspannung wird ermittelt, ob an dem Umrichter ein Erdschluss vorliegt oder nicht.

Ein Nachteil des bekannten Verfahrens besteht unter anderem darin, dass ein Erdschluss, der bereits vor der Inbetriebnahme des Umrichters vorhanden ist, erst im Betrieb desselben ermittelt werden kann. Dies kann zu Schäden an dem Umrichter führen.

Aufgabe der Erfindung ist es, ein Verfahren zum Betreiben einer elektrischen Schaltung zu schaffen, mit der unabhängig von dem eigentlichen Betrieb der Schaltung ein Erdschluss der Schaltung ermittelt werden kann.

Die Erfindung löst diese Aufgabe durch ein Verfahren nach dem Anspruch 1 sowie durch eine elektrische Schaltung nach dem Anspruch 8.

Die elektrische Schaltung ist mit einem mehrere Schalter aufweisenden Stromrichter und parallel dazu mit zwei in Reihe geschalteten Kondensatoren versehen, wobei der Stromrichter zwei wechselstromseitige Anschlüsse aufweist und ausgehend von dem Verbindungspunkt der beiden Kondensatoren ein Messwiderstand nach Erde geschaltet ist. Bei dem erfindungsgemäßen Verfahren wird in Abhängigkeit von einer an dem Messwiderstand abfallenden Messspannung ermittelt, ob ein Erdschluss vorhanden ist, und es werden die Schalter des Stromrichters derart angesteuert, dass an den wechselstromseitigen Anschlüssen des Stromrichters einerseits dasselbe Potential vorhanden ist, und dass sich andererseits dieses Potential von einem ersten auf einen zweiten Wert verändert.

Mit diesem Vorgehen wird erreicht, dass parasitäre Kapazitäten, die unter anderem von den wechselstromseitigen Anschlüssen des Stromrichters nach Erde vorhanden sind, aufgrund der Veränderung des an den wechselstromseitigen Anschlüssen vorhandenen, übereinstimmenden Potentials umgeladen werden. Dieser Umladevorgang hat einen Stromfluss und damit einen Spannungsabfall an dem Messwiderstand zur Folge, der in Abhängigkeit davon, ob ein Erdschluss der elektrischen Schaltung vorliegt oder nicht, unterschiedlich ist. Aus der an dem Messwiderstand abfallenden Messspannung kann somit auf das Vorliegen eines Erdschlusses geschlossen werden. Anstelle der Messspannung kann auch ein Messstrom verwendet werden.

Das erfindungsgemäße Verfahren kann unabhängig vom eigentlichen Betrieb oder auch im Rahmen des eigentlichen Betriebs der elektrischen Schaltung durchgeführt werden. Vorzugsweise kann das Verfahren vor einer Inbetriebnahme der elektrischen Schaltung ausgeführt werden. Damit ist es möglich, einen Erdschluss zu erkennen, ohne dass hierzu ein Betrieb der Schaltung erforderlich ist.

Bei einer Weiterbildung der Erfindung wird ermittelt, ob sich der Spannungsverlauf der Messspannung nach dem Umschalten von dem ersten auf den zweiten Wert im Hinblick auf einen Sollverlauf verändert. Besonders vorteilhaft ist es dabei, wenn der Spannungsverlauf der Messspannung nach dem Umschalten mit dem Sollverlauf verglichen wird, und wenn bei einer wesentlichen Abweichung auf einen Erdschluss geschlossen wird. Durch dieses Vorgehen ist es mit Hilfe eines einfachen Vergleichs von Spannungsverläufen möglich, einen Erdschluss bei der elektrischen Schaltung zu erkennen.

Besonders zweckmäßig ist es, wenn das erfindungsgemäße Verfahren von einem Steuergerät ausgeführt wird, das auch zur Steuerung des Stromrichters vorgesehen ist. In diesem Fall sind keine zusätzlichen Mittel, insbesondere keine zusätzlichen Hardware-Komponenten erforderlich, um die Erfindung zu realisieren.

Weiterhin ist es vorteilhaft, wenn mehrere Stromrichter vorhanden sind, und wenn das erfindungsgemäße Verfahren in diesem Fall an zwei oder mehreren der Stromrichter ausgeführt wird. Damit ist eine genauere Ermittlung oder zumindest Eingrenzung des Ortes eines Erdschlusses möglich.

Weitere Merkmale, Anwendungsmöglichkeiten und Vorteile der Erfindung ergeben sich aus der nachfolgenden Beschreibung von Ausführungsbeispielen der Erfindung, die in den zugehörigen Zeichnungsfiguren dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in den Figuren.

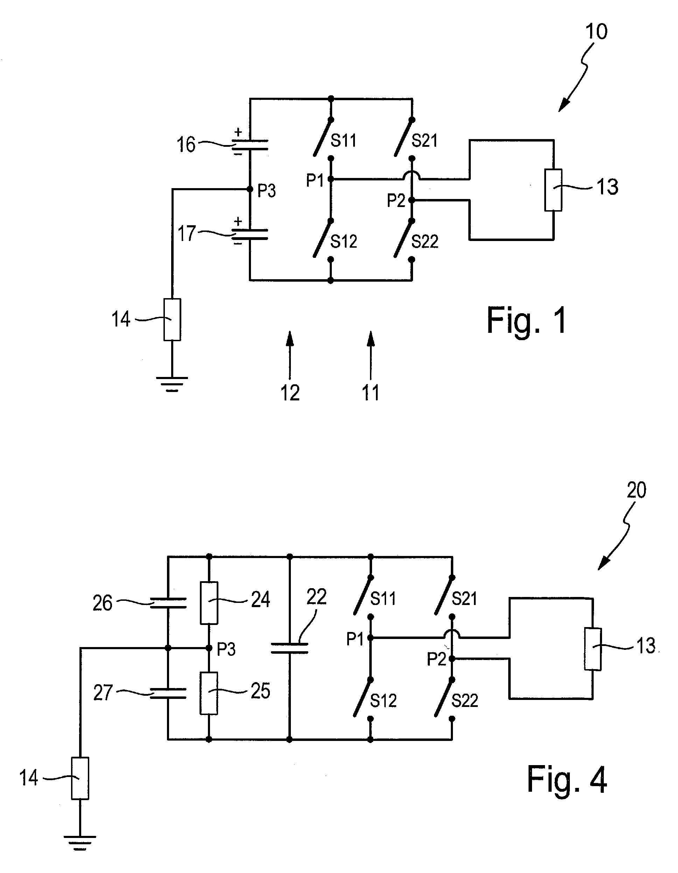

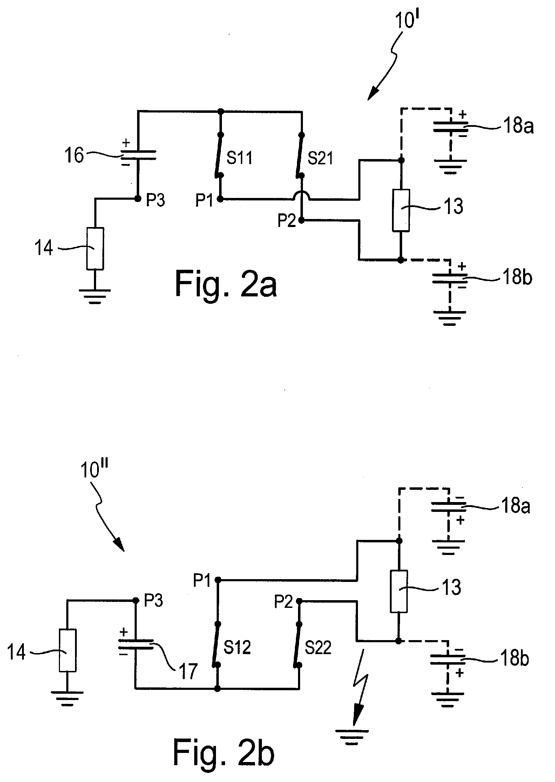

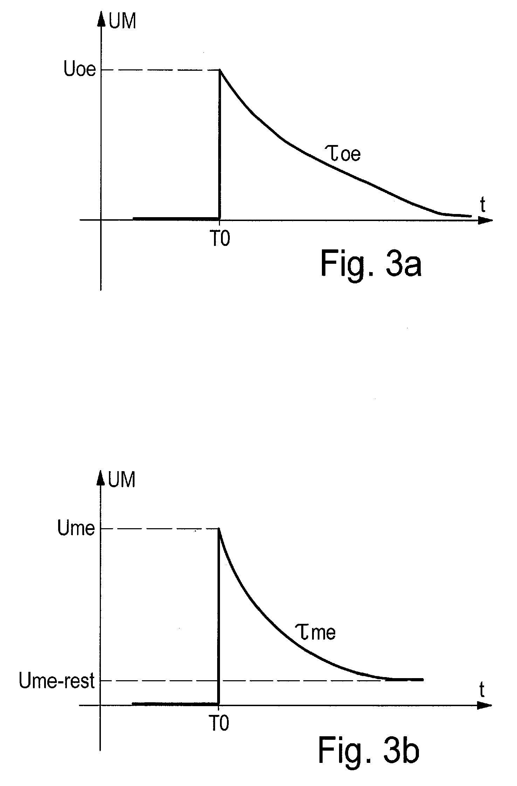

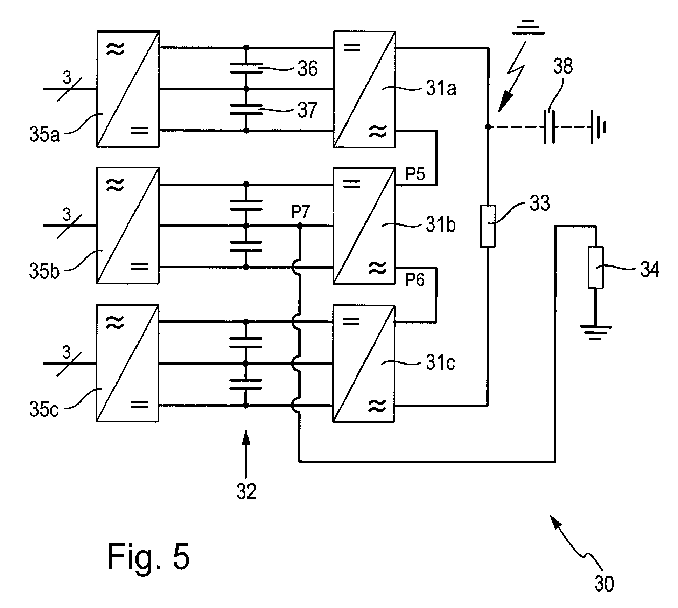

Die Figur 1 zeigt einen elektrischen Schaltplan eines ersten Ausführungsbeispiels einer erfindungsgemäßen elektrischen Schaltung mit einem Stromrichter und einem Messwiderstand, die Figuren 2a, 2b zeigen die Schaltung der Figur 1 in bestimmten Schaltzuständen der Schalter des Stromrichters, die Figuren 3a, 3b zeigen Spannungsverläufe am Messwiderstand der Schaltung der Figur 1, die Figur 4 zeigt einen elektrischen Schaltplan einer alternativen Ausführung der elektrischen Schaltung der Figur 1, und die Figur 5 zeigt einen elektrischen Schaltplan eines zweiten Ausführungsbeispiels einer erfindungsgemäßen elektrischen Schaltung mit einer Reihenschaltung aus mehreren Stromrichtern.

In der Figur 1 ist eine elektrische Schaltung 10 dargestellt, die einen Stromrichter 11, einen Zwischenkreis 12, eine Lastimpedanz 13 und einen Messwiderstand 14 aufweist. Im vorliegenden Ausführungsbeispiel ist der Zwischenkreis 12 zum Zwecke der einfacheren Erläuterung aus zwei in Serie geschalteten Kondensatoren 16, 17 aufgebaut. Letzteres kann auch andersartig vorgesehen sein, wie noch anhand der Figur 4 erläutert werden wird.

Die elektrische Schaltung 10 ist potentialfrei aufgebaut. Dies bedeutet, dass - abgesehen von dem Messwiderstand 14 - keines der Bauteile der elektrischen Schaltung 10 eine betriebliche Verbindung nach Erde aufweist.

Der Stromrichter 11 ist als sogenannte H-Brücke aufgebaut und weist zwei zueinander parallelgeschaltete Serienschaltungen auf, die jeweils zwei Schalter S11, S12, S21, S22 enthalten. Der Verbindungspunkt der Schalter S11, S12 und der Verbindungspunkt der Schalter S21, S22 stellen die wechselstromseitigen Anschlüsse P1, P2 des Stromrichters 11 dar und sind über die Lastimpedanz 13 miteinander verbunden. Die Serienschaltung der beiden Kondensatoren 16, 17 ist zu den beiden vorgenannten Serienschaltungen parallelgeschaltet. Ausgehend von dem Verbindungspunkt P3 der beiden Kondensatoren 16, 17 ist der Messwiderstand 14 nach Erde geschaltet.

Zu den beiden Kondensatoren 16, 17 des Zwischenkreises 12 kann beispielsweise ein weiterer, nicht-dargestellter Stromrichter parallelgeschaltet sein, mit dem unter anderem eine Einspeisung von Energie und damit eine Aufladung der beiden Kondensatoren 16, 17 durchführbar ist. Sofern vorhanden, so ist auch dieser weitere Stromrichter potentialfrei ausgebildet.

Im eigentlichen Betrieb wird der Stromrichter 11 als sogenannter 2-Level-Stromrichter betrieben. Dies bedeutet, dass durch eine entsprechende Ansteuerung der Schalter S11, S12, S21, S22 an den wechselstromseitigen Anschlüssen P1, P2 des Stromrichters 11 entweder das positive Potential oder das negative Potential der beiden in Reihe geschalteten Kondensatoren 16, 17 vorhanden ist.

Zusätzlich zu dem eigentlichen Betrieb der elektrischen Schaltung 10 wird das nachfolgende Verfahren ausgeführt. Vorzugsweise wird dieses Verfahren vor dem eigentlichen Betrieb der elektrischen Schaltung 10 durchgeführt. Das Verfahren kann jedoch auch beispielsweise bei einer gezielten, gegebenenfalls sich wiederholenden, kurzzeitigen Unterbrechung des eigentlichen Betriebs und/oder nach einer Erkennung eines Fehlers beim Betrieb und/oder nach dem Abschalten des Betriebs der elektrischen Schaltung 10 durchgeführt werden. Ebenfalls kann das Verfahren in den eigentlichen Betrieb der elektrischen Schaltung 10 integriert werden.

Zuerst werden die beiden Kondensatoren 16, 17 jeweils auf eine vorgegebene Spannung aufgeladen. Die Spannung liegt an den beiden Kondensatoren 16, 17 der Figur 1 in gleicher Richtung an und ist in den Figuren durch "+" und "-" angedeutet. Das Aufladen der Kondensatoren 16, 17 kann beispielsweise mit Hilfe des erwähnten weiteren Stromrichters erfolgen. Die Schalter S11, S12, S21, S22 können dabei geöffnet sein. Vorzugsweise ist die vorgegebene Spannung kleiner als die übliche Betriebsspannung des Stromrichters 11.

Dann werden die Schalter S11, S12, S21, S22 derart angesteuert, dass die beiden Schalter S11, S21 geschlossen und die beiden Schalter S12, S22 geöffnet sind. Dies entspricht der elektrischen Schaltung 10' der Figur 2a.

Wie sich aus der Figur 2a ergibt, ist dort der positiv aufgeladene Anschluss des Kondensators 16 über den Schalter S11 mit dem Anschluss P1 und über den Schalter S21 mit dem Anschluss P2 verbunden. An den beiden Anschlüssen P1, P2 des Stromrichters 11 liegt damit dasselbe positive Potential an. Dies ist gleichbedeutend damit, dass in einem stationären Zustand an der Lastimpedanz 13 die Spannung "Null" abfällt.

Danach werden die Schalter S11, S12, S21, S22 derart angesteuert, dass die beiden Schalter S12, S22 geschlossen und die beiden Schalter S11, S21 geöffnet sind. Dies entspricht der elektrischen Schaltung 10" der Figur 2b.

Wie sich aus der Figur 2b ergibt, ist dort der negativ aufgeladene Anschluss des Kondensators 17 über den Schalter S12 mit dem Anschluss P1 und über den Schalter S22 mit dem Anschluss P2 verbunden. An den beiden Anschlüssen P1, P2 liegt damit dasselbe negative Potential an. Dies ist gleichbedeutend damit, dass in einem stationären Zustand an der Lastimpedanz 13 die Spannung "Null" abfällt.

Bei beiden Schaltzuständen der Schalter S11, S12, S21, S22 gemäß den Figuren 2a, 2b liegt also an der Lastimpedanz 13 dieselbe Spannung "Null" an. Die beiden Schaltzustände unterscheiden sich jedoch dadurch, dass bei der Figur 2a an beiden Anschlüssen P1, P2 der Lastimpedanz 13 dasselbe positive Potential vorhanden ist, während bei der Figur 2b an beiden Anschlüssen P1, P2 der Lastimpedanz 13 dasselbe negative Potential vorhanden ist.

In den Figuren 2a, 2b sind zusätzlich in gestrichelter Weise parasitäre Kapazitäten 18a, 18b eingezeichnet. Diese parasitären Kapazitäten 18a, 18b sind beispielhaft an die beiden Anschlüsse P1, P2 und damit an die Verbindungen zu der Lastimpedanz 13 angeschlossen. Es versteht sich, dass die parasitären Kapazitäten 18a, 18b auch an anderen Stellen der elektrischen Schaltung 10 vorhanden sein können. Ebenfalls versteht es sich, dass auch noch parasitäre Induktivitäten und/oder parasitäre Widerstände vorhanden sein können.

Wie erläutert wurde, ändert sich beim Umschalten zwischen den beiden Schaltzuständen der Figuren 2a, 2b das Potential an den Anschlüssen P1, P2 des Stromrichters 11 von einem ersten auf einen zweiten Wert. Dies hat zur Folge, dass die parasitären Kapazitäten 18a, 18b umgeladen werden. Mit diesem Umladevorgang ist ein Strom verbunden, der unter anderem über den Messwiderstand 14 fließt.

Wenn man beispielsweise von einem Umschalten von der Figur 2a in die Figur 2b ausgeht, so fließt dieser Strom von dem Kondensator 17 über den Messwiderstand 14 nach Erde, um von dort über die parasitären Kapazitäten 18a, 18b und die beiden geschlossenen Schalter S12, S22 wieder zum Kondensator 17 zu fließen. Durch diesen Strom werden die parasitären Kapazitäten 18a, 18b umgeladen. Über die Lastimpedanz 13 fließen, wenn überhaupt, nur Ausgleichsströme aufgrund von unterschiedlich großen parasitären Kapazitäten 18a, 18b auf beiden Seiten der Lastimpedanz 13.

Der über den Messwiderstand 14 fließende Strom ändert sich im Zeitpunkt des Umschaltens auf einen Wert ungleich Null und klingt dann aufgrund der sich aufladenden parasitären Kapazitäten 18a, 18b wieder auf Null ab. Dieser Stromfluss hat zur Folge, dass an dem Messwiderstand 14 eine entsprechende Messspannung UM abfällt. Diese Messspannung UM wird gemessen.

In den Figuren 3a, 3b ist jeweils der Verlauf der Messspannung UM über der Zeit t aufgetragen. Bei der Figur 3a ist dabei kein Erdschluss der elektrischen Schaltung 10 vorhanden, während bei der Figur 3b zumindest ein Erdschluss von irgendeinem Bauteil der elektrischen Schaltung 10 nach Erde angenommen wird. Das Umschalten von den Schaltzuständen der Schalter gemäß der Figur 2a zu denjenigen gemäß der Figur 2b findet bei den Figuren 3a, 3b in einem Zeitpunkt T0 statt.

Bei der Figur 3a wird, wie gesagt, davon ausgegangen, dass bei der elektrischen Schaltung 10 kein Erdschluss vorhanden ist. Dies bedeutet, dass - abgesehen von dem Messwiderstand 14 - tatsächlich keines der Bauteile der elektrischen Schaltung 10 eine Verbindung nach Erde aufweist.

Aufgrund des erläuterten, beim Umschalten fließenden Stroms springt die Messspannung UM in der Figur 3a auf eine bestimmte Spannung Uoe und klingt dann mit einer Zeitkonstante τoe wieder auf Null ab.

Aufgrund des Umschaltens von der Figur 2a zu der Figur 2b ist die Spannung Uoe positiv. Die Größe der Spannung Uoe ist abhängig von den Betriebsgrößen der elektrischen Schaltung. Die Spannung Uoe kann vorab rechnerisch oder durch Versuche ermittelt werden.

Die Zeitkonstante τoe für das Abklingen der Messspannung Um von der Spannung Uoe auf Null ist insbesondere abhängig vom Messwiderstand 14 und von den parasitären Kapazitäten 18a, 18b und kann vorzugsweise vorab durch Versuche ermittelt werden.

Der Spannungsverlauf gemäß der Figur 3a für die elektrische Schaltung 10 ohne Erdschluss kann somit vorab ermittelt und beispielsweise gespeichert werden. Dieser Spannungsverlauf ist charakteristisch für den Zustand "ohne Erdschluss" und wird nachfolgend auch als Sollverlauf bezeichnet.

Wie erwähnt, wird bei der Figur 3b davon ausgegangen, dass bei der elektrischen Schaltung 10 ein Erdschluss vorhanden ist. Dieser Erdschluss ist in der Figur 2b beispielhaft an dem Anschluss P2 des Stromrichters 11 vorhanden und mit einem Blitz nach Erde gekennzeichnet.

Der Erdschluss kann, beispielsweise bei einem Wasserschaden oder dergleichen, eher hochohmig oder, beispielsweise bei metallischen Kurzschlüssen, niederohmig sein.

Durch den vorstehend genannten Erdschluss werden die von dem Anschluss P2 nach Erde an sich vorhandenen parasitären Kapazitäten 18b zumindest in ihrem Wert verändert oder gar vollständig kurzgeschlossen. Damit verändert sich der Stromfluss beim Umschalten von der Figur 2a in die Schaltzustände der Figur 2b. Dies hat zur Folge, dass auch die Messspannung UM der Figur 3b von der Messspannung UM der Figur 3a abweicht.

So ändert sich die Messspannung UM bei der Figur 3b auf eine Spannung Ume, die verschieden zu der Spannung Uoe der Figur 3a sein kann. Weiterhin kann sich bei der Figur 3b die Zeitkonstante τme, mit der die Messspannung UM wieder abklingt, im Vergleich zu der Zeitkonstante τoe der Figur 3a ändern. Und weiterhin kann bei der Figur 3b im Vergleich zur Figur 3a eine stationäre Restspannung Ume-rest bestehen bleiben.

Die vorstehend erläuterten Veränderungen der Spannung Ume, der Zeitkonstante ime und der Restspannung Ume-rest können dabei alternativ oder kumulativ auftreten.

Dann wird ermittelt, ob der Spannungsverlauf der gemessenen Messspannung UM nach einem Umschaltvorgang von dem erläuterten Sollverlauf abweicht. Ist dies innerhalb von vorgebbaren Schwellwerten nicht der Fall, so wird davon ausgegangen, dass kein Erdschluss vorliegt. Wenn jedoch der Spannungsverlauf der Messspannung bei einem Umschaltvorgang von dem erläuterten Sollverlauf wesentlich abweicht, insbesondere wenn der gemessene Spannungsverlauf die vorgegebenen Schwellwerte überschreitet, dann wird davon ausgegangen, dass bei der elektrischen Schaltung 10 ein Erdschluss vorliegt, dass also ein Bauteil der elektrischen Schaltung 10 eine Anbindung nach Erde aufweist.

Das vorstehend beschriebene Verfahren wird von einem Steuergerät durchgeführt, das dazu geeignet ist, die Schalter S11, S12, S21, S22 in die erwünschten Schaltzustände zu schalten. Die Schalter S11, S12, S21, S22 können zu diesem Zweck als ansteuerbare Leistungshalbleiterbauelemente oder -module ausgebildet sein, beispielsweise als IGBTs (IGBT = insulated gate bipolar transistor) oder dergleichen. Dem Steuergerät ist weiterhin die Messspannung UM zugeführt.

Bei dem Steuergerät kann es sich beispielsweise um einen Computer handeln, der mit Programmen versehen ist, mit denen das erläuterte Verfahren ausgeführt werden kann. Vorzugsweise handelt es sich bei dem Steuergerät um dieselbe Einrichtung, mit der auch der Stromrichter 11 gesteuert wird.

Es versteht sich, dass das erläuterte Verfahren auch dahingehend geändert werden kann, dass von den Schaltzuständen der Figur 2b zu den Schaltzuständen der Figur 2a umgeschaltet wird. Weiterhin versteht es sich, dass anstelle der Messspannung UM auch ein über den Messwiderstand 14 fließender Strom gemessen und dem vorstehend erläuterten Verfahren zugrundegelegt werden kann.
Wie eingangs erwähnt wurde, weist der Zwischenkreis 12 der elektrischen Schaltung 10 zum Zwecke der einfacheren Erläuterung die beiden in Reihe geschalteten Kondensatoren 16, 17 auf. In der Figur 4 ist nunmehr eine elektrische Schaltung 20 dargestellt, die weitgehend mit der elektrischen Schaltung 10 der Figur 1 übereinstimmt.

Im Unterschied zur elektrischen Schaltung 10 der Figur 1 weist die elektrische Schaltung 20 der Figur 4 jedoch einen einzigen, den Zwischenkreis 12 bildenden Zwischenkreiskondensator 22. Parallel zu diesem Zwischenkreiskondensator 22 ist in der Figur 4 eine aus zwei Serienschaltungen bestehende Parallelschaltung geschaltet, wobei die erste Serienschaltung aus zwei Widerständen 24, 25 und die zweite Serienschaltung aus zwei Kondensatoren 26, 27 besteht. Die Verbindungspunkte der beiden Widerstände 24, 25 sowie der beiden Kondensatoren 26, 27 bilden den Verbindungspunkt P3, an den der Messwiderstand 14 angeschlossen ist. Mit Hilfe der Widerstände 24, 25 und der Kondensatoren 26, 27 wird ein Spannungsteiler gebildet, der die an dem Zwischenkreiskondensator 22 anliegende Spannung in zwei Teile aufteilt.

Die Funktionsweise der elektrischen Schaltung 20 der Figur 4 entspricht im Wesentlichen der anhand der Figuren 1, 2a, 2b, 3a, 3b bereits vorgenommenen Beschreibung der elektrischen Schaltung 10. Insoweit sind gleichartige Bauteile der Figur 4 auch mit gleichen Bezugszeichen versehen. Weiterhin entsprechen die in der elektrischen Schaltung 20 der Figur 4 vorhandenen Kondensatoren 26, 27 den Kondensatoren 16, 17 der elektrischen Schaltung 10.
In der Figur 5 ist eine elektrische Schaltung 30 dargestellt, die eine erste Anzahl von Stromrichtern 31a, 31b, 31c, einen Zwischenkreis 32, eine Lastimpedanz 33, einen Messwiderstand 34 und eine zweite Anzahl von Stromrichtern 35a, 35b, 35c aufweist.
Die elektrische Schaltung 30 ist - abgesehen von dem Messwiderstand 34 - potentialfrei aufgebaut.
Im vorliegenden Ausführungsbeispiel handelt es sich bei jedem der ersten und der zweiten Anzahl von Stromrichtern 31a, 31b, 31c, 35a, 35b, 35c um einen sogenannten 3-Level-Stromrichter, der an seinen wechselspannungsseitigen Anschlüssen P5, P6 entweder ein positives Potential, ein Null-Potential oder ein negatives Potential erzeugen kann.
Im vorliegenden Ausführungsbeispiel sind die erste Anzahl von Stromrichtern 31a, 31b, 31c mit ihren wechselspannungsseitigen Anschlüssen in Reihe geschaltet.

Weiterhin sind die zweite Anzahl von Stromrichtern 35a, 35b, 35c im vorliegenden Ausführungsbeispiel jeweils dreiphasig ausgebildet.
Es wird darauf hingewiesen, dass die Stromrichter nicht nur als 3-Level-Stromrichter, also dreistufig ausgebildet sein können, sondern dass sie eine beliebige Anzahl von Stufen aufweisen können, beispielsweise in der Form von 5-Level-Stromrichtern. Ebenfalls wird darauf hingewiesen, dass die Stromrichter nicht nur dreiphasig ausgebildet sein können, sondern dass sie auch eine andere Anzahl von Phasen aufweisen können.
Im vorliegenden Ausführungsbeispiel sind jeweils drei Stromrichter auf beiden Seiten des Zwischenkreises 32 vorhanden. Es wird darauf hingewiesen, dass diese erste Anzahl und/oder zweite Anzahl auch kleiner oder größer sein kann.

Der Zwischenkreis 32 weist eine Anzahl von Kondensatoren auf, wobei jedem der ersten Anzahl von Stromrichtern 31a, 31b, 31c jeweils eine Serienschaltung bestehend aus zwei Kondensatoren 36, 37 zugeordnet ist. Die jeweiligen drei Anschlusspunkte der Kondensatoren 36, 37 sind mit den gleichspannungsseitigen Anschlüssen der jeweils zugehörigen Stromrichter 31a, 31b, 31c, 35a, 35b, 35c verbunden.
Der Messwiderstand 34 ist ausgehend von dem Verbindungspunkt P7 der zu dem mittleren Stromrichter 31b zugehörigen beiden Kondensatoren 36, 37 nach Erde geschaltet. An dem Messwiderstand 34 liegt eine Messspannung UM an.
In vergleichbarer Weise wie bei der elektrischen Schaltung 10 der Figur 1, so werden auch bei der elektrischen Schaltung 30 der Figur 5 zuerst sämtliche Kondensatoren 36, 37 auf eine vorgegebene Spannung aufgeladen. Dies kann mit Hilfe der zweiten Anzahl von Stromrichtern 35a, 35b, 35c vorgenommen werden. Dann werden die Schalter der ersten Anzahl von Stromrichtern 31a, 31b, 31c derart angesteuert, dass an allen wechselspannungsseitigen Anschlüssen dieser Stromrichter das Null-Potential vorhanden ist. Dann werden beispielsweise die Schalter nur des mittleren Stromrichters 31b derart umgeschaltet, dass an den wechselspannungsseitigen Anschlüssen P5, P6 dieses mittleren Stromrichters 31b ein positives Potential vorhanden ist. Die Schalter der übrigen Stromrichter 31a, 31b bleiben unverändert.

In beiden Schaltzuständen der Schalter der ersten Anzahl von Stromrichtern 31a, 31b, 31c liegt an der Lastimpedanz 33 die Spannung "Null" an.

Bei dem Umschaltvorgang von dem ersten in den zweiten Schaltzustand verändert sich das Potential an den Anschlüssen P5, P6 des mittleren Stromrichters 31b von dem Null-Potential auf das positive Potential. Dies führt aufgrund von parasitären Kapazitäten 38 in vergleichbarer Weise zu einem Stromfluss und damit zu einem Spannungsverlauf der Messspannung UM, wie dies bereits für die elektrische Schaltung 10 der Figur 1 anhand der Figur 3a erläutert worden ist.

Liegt kein Erdschluss bei der elektrischen Schaltung 30 der Figur 5 vor, so stellt der Spannungsverlauf der Messspannung UM wieder einen Sollverlauf dar, der beispielsweise vorab anhand von Versuchen ermittelt werden kann.

Liegt jedoch ein Erdschluss vor, wie dies in der Figur 5 durch einen Blitz gekennzeichnet ist, so verändert sich der Einfluss der parasitären Kapazitäten 38 und damit der Spannungsverlauf der Messspannung UM. Weicht der Spannungsverlauf der Messspannung UM wesentlich von dem Sollverlauf ab, so kann daraus auf einen Erdschluss der elektrischen Schaltung 30 der Figur 5 geschlossen werden.

Es wird darauf hingewiesen, dass anstelle des positiven Potentials bei dem zweiten Schaltzustand auch ein negatives Potential an den wechselstromseitigen Anschlüssen P5, P6 des mittleren Stromrichters 31b erzeugt werden kann. In diesem Fall führt dies bei dem Umschaltvorgang von dem ersten in den zweiten Schaltzustand dazu, dass sich dieses Potential von dem Null-Potential auf das negative Potential verändert. Dies hat in gleicher Weise eine Messspannung UM zur Folge, wie dies bereits erläutert worden ist.

Ebenfalls ist es möglich, dass das Potential an den wechselstromseitigen Anschlüssen P5, P6 des mittleren Stromrichters 31b bei dem Umschaltvorgang von einem positiven auf ein negatives Potential verändert wird. Auch dies führt in entsprechender Weise zu einer Messspannung UM.

Die Messspannung UM kann nicht nur, wie erläutert wurde, an dem mittleren Stromrichter 31b abgegriffen werden, sondern an jedem der vorhandenen Stromrichter 31a, 31b, 31c. Es kann dabei, wie erläutert wurde, nur eine einzige Messspannung abgegriffen werden oder auch zwei oder mehrere Messspannungen in beliebiger Kombination. Werden mehrere Messspannungen an den Stromrichtern 31a, 31b und/oder 31c abgegriffen, so kann durch eine entsprechende Auswertung der Ort des Erdschlusses lokalisiert oder zumindest eingegrenzt werden.

## Patentansprüche

1. Verfahren zum Betreiben einer elektrischen Schaltung (10; 20; 30), wobei die Schaltung einen mehrere Schalter aufweisenden Stromrichter (11; 31a, 31b, 31 c) und parallel dazu zwei in Reihe geschaltete Kondensatoren (16, 17; 26, 27; 36, 37) aufweist, wobei der Stromrichter zwei wechselstromseitige Anschlüsse (P1, P2; P5, P6) und mindestens zwei gleichspannungsseitige Anschlüsse aufweist, wobei die Kondensatoren zwischen den gleichspannungsseitigen Anschlüssen verbunden sind, und ausgehend von dem Verbindungspunkt (P3; P7) der befden Kondensatoren ein Messwiderstand (14; 34) nach Erde geschaltet ist, und wobei bei dem Verfahren in Abhängigkeit von einer an dem Meßwiderstand abfallenden Messspannung (UM) ermittelt wird, ob ein Erdschluss vorhanden ist, **dadurch gekennzeichnet, dass** die Schalter des Stromrichters (11; 31a, 31b, 31 c) derart angesteuert werden, dass an den wechselstromseitigen Anschlüssen (P1, P2; P5, P6) des Stromrichters einerseits dasselbe Potential vorhanden ist, und dass sich andererseits dieses Potential von einem ersten auf einen zweiten Wert verändert.

2. Verfahren nach Anspruch 1, wobei ermittelt wird, ob sich der Spannungsverlauf der Messspannung (UM) nach dem Umschalten von dem ersten auf den zweiten Wert im Hinblick auf einen Sollverlauf verändert.

3. Verfahren nach Anspruch 2, wobei der Spannungsverlauf der Messspannung (UM) nach dem Umschalten mit dem Sollverlauf verglichen wird, und wobei bei einer wesentlichen Abweichung auf einen Erdschluss geschlossen wird.

4. Verfahren nach Anspruch 2 oder 3, wobei der Sollverlauf aus dem Spannungsverlauf der Messspannung (UM) ermittelt wird, wenn kein Erdschluss vorliegt.

5. Verfahren nach Anspruch 4, wobei der 5ollverlauf varab durch Berechnungen und/oder Versuche ermittelt wird.

6. Verfahren nach einem der vorstehenden Ansprüche, wobei anstelle der Messspannung (UM) ein über den Messwiderstand (14;34) fließender Messstrom verwendet wird.

7. Verfahren nach einem der vorstehenden Ansprüche, wobei mehrere Stromrichter (31 a, 31 b, 31 c) vorhanden sind, und wobei das "Verfahren an zwei oder mehreren der Stromrichter durchgeführt wird.

8. Elektrische Schaltung (10; 20; 30) mit einem mehrere Schalter aufweisenden Stromrichter (11; 31a, 31b, 31c) und parallel dazu zwei in Reihe geschalteten Kondensatoren (16, 17; 26, 27, 36, 37), wobei der Stromrichter zwei wechselstromseitige Anschlüsse (P1, P2; P5, P6) und mindestens zwei gleichspannungsseitige Anschlüsse aufweist, wobei die Kondensatoren zwischen den gleichspannungsseitigen Anschlüssen verbunden sind, und ausgehend von dem Verbindungspunkt (P3; P7) der beiden Kondensatoren ein Messwiderstand (14; 34) nach Erde geschaltet ist, sowie mit einem Steuergerät, **dadurch gekennzeichnet, dass** das Steuergerät dazu hergerichtet ist, das Verfahren nach einem der Ansprüche 1 bis 7 auszuführen.

9. Elektrische Schaltung (10; 20; 30) nach Anspruch 8, wobei das Steuergerät auch zur Steuerung des Stromrichters hergerichtet ist.

10. Elektrische Schaltung (30) nach einem der Ansprüche 8 oder 9, wobei mehrere Stromrichter (31a, 31b, 31c) vorhanden sind, und wobei zwei oder mehrere der Stromrichter dazu hergerichtet sind, das Verfahren nach einem der Ansprüche 1 bis 7 auszuführen.

## Claims

1. Method for operating an electrical circuit (10; 20; 30), wherein the circuit comprises a converter (11; 31a,31 b, 31c) with several switches and parallel therewith two series-connected condensers (16, 17; 26, 27; 36, 37), wherein the converter has two ports (P1, P2; P5, P6) on the alternating current side and at least two ports on the direct current side, wherein the condensers are connected between the ports on the direct current side, and starting from the connecting point (P3; P7) of the two condensers, a measurement resistance (14, 34) is switched to ground, and wherein in the method, depending on a measurement voltage (UM) dropping at the measurement resistance, it is determined whether a ground fault is present, **characterised in that** the switches of the converter (11; 31a, 31b, 31c) are controlled such that firstly the same potential is present at the ports (P1, P2; P5, P6) on the alternating current side of the converter, and that secondly this potential changes from a first to a second value.

2. Method according to claim 1, wherein it is determined whether the voltage curve of the measurement voltage (UM) changes relative to a nominal curve after the switching from the first to the second value.

3. Method according to claim 2, wherein the voltage curve of the measurement voltage (UM) is compared with the nominal curve after the switching, and wherein a ground fault is concluded if a substantial deviation is found.

4. Method according to claim 2 or 3, wherein the nominal curve is determined from the voltage curve of the measurement voltage (UM) if no ground fault is present.

5. Method according to claim 4, wherein the nominal curve is determined in advance by calculation and/or experimentation.

6. Method according to any of the preceding claims, wherein instead of the measurement voltage (UM), a measurement current flowing over the measurement resistance (14; 34) is used.

7. Method according to any of the preceding claims, wherein several converters (31 a, 31b, 31c) are present, and wherein the method is performed on two or more of the converters.

8. Electrical circuit (10; 20; 30) with a converter (11; 31a; 31b, 31c) with several switches and parallel therewith two series-connected condensers (16, 17; 26, 27; 36, 37), wherein the converter has two ports (P1, P2; P5, P6) on the alternating current side and at least two ports on the direct current side, wherein the condensers are connected between the ports on the direct current side, and starting from the connecting point (P3; P7) of the two condensers, a measurement resistance (14, 34) is switched to ground, and with a control unit, **characterised in that** the control unit is configured to perform the method according to any of claims 1 to 7.

9. Electrical circuit (10; 20; 30) according to claim 8, wherein the control unit is also configured to control the converter.

10. Electrical circuit (10; 20; 30) according to one of claims 8 or 9, wherein several converters (31 a, 31 b, 31c) are present, and wherein two or more of the converters are configured to perform the method according to any of claims 1 to 7.

## Revendications

1. Procédé pour faire fonctionner un circuit électrique (10; 20; 30), sachant que le circuit présente un convertisseur de courant (11; 31a, 31b, 31c), comportant plusieurs commutateurs, et, parallèlement à celui-ci, deux condensateurs (16, 17; 26, 27; 36, 37) montés en série, sachant que le convertisseur de courant présente deux bornes (P1, P2; P5, P6) côté courant alternatif et au moins deux bornes côté tension continue, sachant que les condensateurs sont connectés entre les bornes côté tension continue et, partant du point de connexion (P3; P7) des deux condensateurs, une résistance de mesure (14; 34) est mise à la terre, et sachant que selon le procédé on détermine, en fonction d'une tension de mesure (UM) diminuant sur la résistance de mesure, s'il y a un défaut à la terre, **caractérisé en ce que** les commutateurs du convertisseur de courant (11; 31a, 31b, 31c) sont activés de manière telle que d'une part, le même potentiel soit présent aux bornes (P1, P2; P5, P6) côté courant alternatif du convertisseur de courant, et que d'autre part, ce potentiel change et passe d'une première à une deuxième valeur.

2. Procédé selon la revendication 1, selon lequel on détermine si, après la commutation de la première à la deuxième valeur, la variation de tension de la tension de mesure (UM) se modifie par rapport à une variation de consigne.

3. Procédé selon la revendication 2, selon lequel, après la commutation, la variation de tension de la tension de mesure (UM) est comparée avec la variation de consigne et, en cas d'écart significatif, on conclut à un défaut à la terre.

4. Procédé selon la revendication 2 ou 3, selon lequel la variation de consigne est déterminée à partir de la variation de tension de la tension de mesure (UM), s'il n'y a pas de défaut à la terre.

5. Procédé selon la revendication 4, selon lequel la variation de consigne est déterminée au préalable par des calculs et/ou des essais.

6. Procédé selon l'une des revendications précédentes, selon lequel on utilise, à la place de la tension de mesure (UM), un courant de mesure passant par la résistance de mesure (14; 34).

7. Procédé selon l'une des revendications précédentes, selon lequel il y a plusieurs convertisseurs de courant (31a, 31b, 31c), et sachant que le procédé est mis en oeuvre sur deux ou plusieurs des convertisseurs de courant.

8. Circuit électrique (10; 20; 30) comprenant un convertisseur de courant (11; 31a, 31b, 31c), comportant plusieurs commutateurs, et, parallèlement à celui-ci, deux condensateurs (16, 17; 26, 27; 36, 37) montés en série, sachant que le convertisseur de courant présente deux bornes (P1, P2; P5, P6) côté courant alternatif et au moins deux bornes côté tension continue, sachant que les condensateurs sont connectés entre les bornes côté tension continue et, partant du point de connexion (P3; P7) des deux condensateurs, une résistance de mesure (14; 34) est mise à la terre, et comprenant un appareil de commande, **caractérisé en ce que** l'appareil de commande est conçu pour mettre en oeuvre le procédé selon l'une des revendications 1 à 7.

9. Circuit électrique (10; 20; 30) selon la revendication 8, selon lequel l'appareil de commande est également conçu pour la commande du convertisseur de courant.

10. Circuit électrique (30) selon l'une des revendications 8 ou 9, sachant qu'il existe plusieurs convertisseurs de courant (31a, 31b, 31c), et sachant que deux ou plusieurs des convertisseurs de courant sont conçus pour mettre en oeuvre le procédé selon l'une des revendications 1 à 7.
